# EUROPEAN PATENT APPLICATION

(11) **EP 4 742 242 A1**
(43) Date of publication of application: **13.05.2026**
(21) Application number: 25183599.7
(22) Date of filing: 18.06.2025
(51) Int. Cl.: G11C 5/02, G11C 7/18, G11C 11/4097, H10B 12/00, G11C 5/06

(54) **MEMORY DEVICE**

(30) Priority: 07.11.2024 KR 20240157076
(71) Applicant: Samsung Electronics Co., Ltd., Suwon-si, Gyeonggi-do 16677 (KR)
(72) Inventor: SEO, Duckyoung, 16677 Suwon-si, Gyeonggi-do (KR); KANG, Kyu-Chang, 16677 Suwon-si, Gyeonggi-do (KR)
(74) Representative: Kuhnen & Wacker Patent- und Rechtsanwaltsbüro PartG mbB

(57) **Abstract**

A memory device (400) includes a first memory cell array (MCA1) including a plurality of bit lines (BL); a second memory cell array (MCA2) including a plurality of complementary bit lines (BLB) corresponding to the plurality of bit lines (BL), and arranged adjacent to the first memory cell array (MCA1) in a first direction (D1); and a first bit line sense amplifier array (BSA1) having at least a portion overlapping the first memory cell array (MCA1) on the first memory cell array (MCA1), and including a plurality of first bit line sense amplifiers (BLSA1, BLSA2, BLSA5, BLSA6) connected to a plurality of first bit lines among the plurality of bit lines (BL) and a plurality of first complementary bit lines among the plurality of complementary bit lines (BLB).

## Description

### BACKGROUND

Volatile memory devices, such as dynamic random access memories (DRAM), store a data by storing charges in a capacitive load (a capacitor) of a memory cell, and read a data by determining the charges stored in the capacitor.

A bit line sense amplifier may be connected to the memory cell to sense the data stored in the memory cell. The bit line sense amplifier may detect and amplify the voltage difference between the bit line and a complementary bit line determined depending on the data stored in the memory cell.

Meanwhile, when designing the DRAM by adopting an open bit line structure, a dummy bit line is required for sensing an outermost memory cell array block, which may be a factor that deteriorates the integration or fabrication efficiency of the semiconductor memory device, such as a gross die per wafer or a net die per wafer.

### SUMMARY

Some aspects of this disclosure relate to memory devices that may provide higher gross die per wafer, and/or other advantages as discussed herein.
A memory device according to some implementations of the present disclosure may include a first memory cell array including a plurality of bit lines; a second memory cell array including a plurality of complementary bit lines corresponding to the plurality of bit lines, and arranged adjacent to the first memory cell array in a first direction; and a first bit line sense amplifier array having at least a portion overlapping the first memory cell array on the first memory cell array, and including a plurality of first bit line sense amplifiers connected to a plurality of first bit lines among the plurality of bit lines and a plurality of first complementary bit lines among the plurality of complementary bit lines.

A memory device according to some implementations of the present disclosure may include a first substrate including a first mat including a plurality of first memory cells and a plurality of bit lines connected to the plurality of first memory cells, and a second mat including a plurality of second memory cells and a plurality of complementary bit lines connected to the plurality of second memory cells; and a second substrate positioned above the first substrate and including a bit line sense amplifier connected to one the plurality of bit lines and one of the plurality of complementary bit lines corresponding to one of the plurality of bit lines and disposed on the first mat.

A memory device according to some implementations of the present disclosure may include a first memory cell array including a plurality of bit lines; a second memory cell array including a plurality of complementary bit lines and arranged adjacent to the first memory cell array in a first direction; a first bit line sense amplifier array disposed on the first memory cell array and connected to a plurality of first bit lines among the plurality of bit lines and a plurality of first complementary bit lines among the plurality of complementary bit lines; and a second bit line sense amplifier array disposed on the second memory cell array and connected a plurality of second bit lines different from the plurality of first bit lines among the plurality of bit lines, and a plurality of second complementary bit lines different from the plurality of first complementary bit lines among the plurality of complementary bit lines.

### BRIEF DESCRIPTION OF THE DRAWINGS

FIG. 1 is a block diagram illustrating an example of a memory device.
FIG. 2 is a perspective diagrammatic view illustrating an example of a memory device.
FIG. 3 is a diagram illustrating an example of a memory device as shown in FIG. 2.
FIG. 4 is a perspective diagrammatic view illustrating an example of a memory device.
FIG. 5 is a diagram illustrating an example of a memory device as shown in FIG. 4.
FIG. 6 is a diagram illustrating an example of a memory device.
FIG. 7 is a diagram illustrating an example of a memory cell array included in a memory device.
FIG. 8 is a circuit diagram illustrating an example of a bit line sense amplifier included in a memory device.
FIG. 9 is a diagram illustrating an example of a memory device.
FIG. 10 is a diagram illustrating an example of a memory device.
FIG. 11 is a diagram illustrating an example of a memory device.
FIG. 12 is a diagram illustrating an example of a.
FIG. 13 is a perspective diagrammatic view illustrating an example of a memory device.
FIG. 14 is a cross-sectional view of an example of a memory device.
FIG. 15 is a cross-sectional view of am example of a memory device.
FIG. 16 is a block diagram illustrating an example of a computing device.

### DETAILED DESCRIPTION

In the following detailed description, certain examples are described by way of illustration. As those skilled in the art would realize, the described examples may be modified in various different ways.

Like reference numerals designate like elements throughout the specification. In flowcharts described with reference to the drawings, the order of operations or steps may be changed, several operations or steps may be merged, a certain operation or step may be divided, and a specific operation or step may not be performed, without departing from the scope of this disclosure.

In the description, expressions described in the singular in this specification may be interpreted as the singular or plural unless an explicit expression such as "one" or "single" is used. Terms including ordinal numbers such as first, second, and the like will be used only to describe various components, and are not interpreted as limiting these components to a particular order unless indicated otherwise. The terms are only used to differentiate one component from other components, unless indicated otherwise.

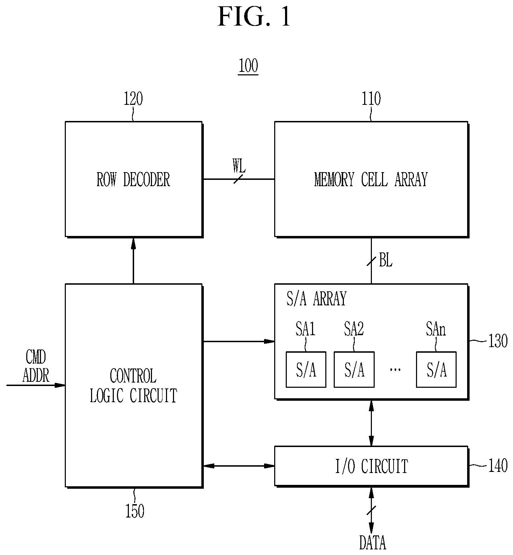

FIG. 1 is a block diagram illustrating an example of a memory device. Referring to FIG. 1, a memory device 100 may include a memory cell array 110, a row decoder 120, a bit line sense amplifier array 130, an input/output circuit 140, and a control logic circuit 150.

The memory cell array 110 may include a plurality of memory cells arranged in a row direction and a column direction. The plurality of memory cells may be connected to a plurality of word lines WL extending in the row direction and a plurality of bit lines BL extending in the column direction.

For purposes of illustration, examples in which each of the plurality of memory cells is a dynamic random access memory (DRAM) cell will be described below as a representative example. However, the memory cells are not limited thereto, and each of the plurality of memory cells may be any type of volatile memory cell, such as a static random access memory (SRAM) cell, or any type of non-volatile memory cell, such as a flash memory cell. That is, the scope of the present disclosure is not limited to the type of the memory device 100.

The row decoder 120 may control the plurality of word lines WL. For example, the row decoder 120 may activate some of the plurality of word lines WL based on an address ADDR provided to the control logic circuit 150.

The bit line sense amplifier array 130 may include a plurality of bit line sense amplifiers SA. For example, the bit line sense amplifier array 130 may include first to n-the bit line sense amplifiers SA1 to SAn.

The plurality of bit line sense amplifiers SA1 to SAn may be connected to the plurality of bit lines BL, respectively. For example, each of the plurality of bit line sense amplifiers SA1 to SAn may be connected to a bit line and a bit line (hereinafter, referred to as a complementary bit line) complementary thereof, respectively. The plurality of bit line sense amplifiers SA1 to SAn may detect and amplify a voltage level change of the connected bit line BL based on a voltage level difference between the connected bit line and complementary bit line, respectively.

The input/output circuit 140 may output a data corresponding to the voltage level change of the bit line BL amplified by the bit line sense amplifier array 130 to the outside or receive a data from the outside.

The control logic circuit 150 may receive a command CMD and an address ADDR. The control logic circuit 150 may control the overall operations of the memory device 100 based on the command CMD and the address ADDR.

In some implementations, the control logic circuit 150 may provide a plurality of control signals to the bit line sense amplifier arrays 130. For example, the control logic circuit 150 may provide the plurality of control signals to the bit line sense amplifier array 130 to control the operation of each of the plurality of bit line sense amplifiers S/A.

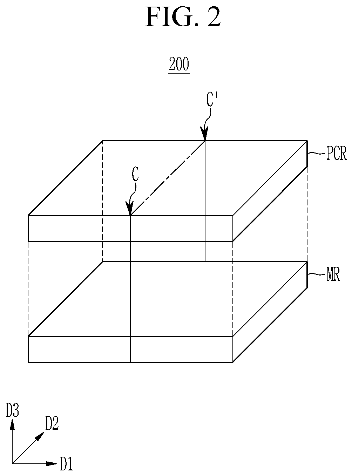

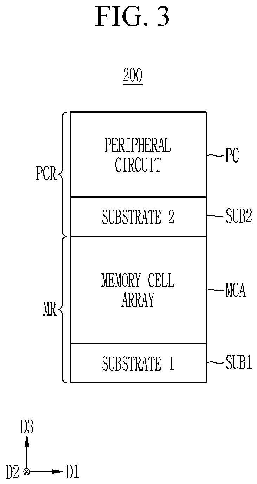

FIG. 2 is a perspective diagrammatic view illustrating an example of a memory device. FIG. 3 is a diagram illustrating a memory device, e.g., a memory device as illustrated in FIG. 2.

Referring to FIG. 2 and FIG. 3, the memory device 200 may include a memory region MR and a peripheral circuit region PCR. The peripheral circuit region PCR may be three-dimensionally stacked on the memory region MR along a third direction D3. That is, the memory device 200 may have a peri on cell (PoC) structure.

The memory region MR may include a first substrate SUB1 and a memory cell array MCA (e.g., the memory cell array 110 illustrated in FIG. 1) formed on the first substrate SUB1. The peripheral circuit region PCR may include a second substrate SUB2 and a peripheral circuit PC (e.g., the row decoder 120, the bit line sense amplifier array 130, the input/output circuit 140, and the control logic circuit 150 as shown in FIG. 1) formed on the second substrate SUB2. In the following, the memory cell array MCA may also be referred to as a MAT or a mat.

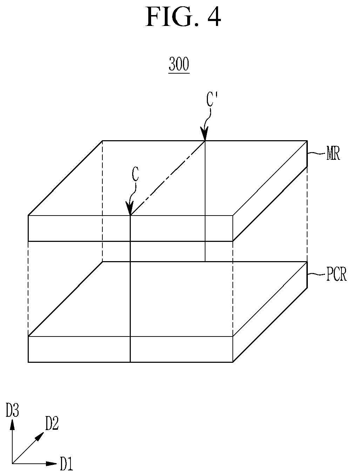

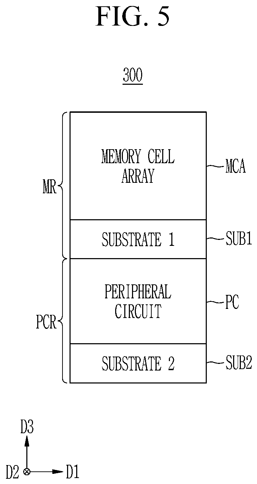

FIG. 4 is a perspective diagrammatic view illustrating an example of a memory device. FIG. 5 is a diagram illustrating an example of a memory device, e.g., a memory device as illustrated in FIG. 4.

Referring to FIG. 4 and FIG. 5, the memory device 300 may include a peripheral circuit region PCR and a memory region MR. The memory cell region MR may be three-dimensionally stacked on the peripheral circuit region PCR along the third direction D3. That is, the memory device 300 may have a cell on peri (CoP) structure.

The peripheral circuit region PCR may include a second substrate SUB2 and a peripheral circuit PC (the row decoder 120, the bit line sense amplifier array 130, the input/output circuit 140, and the control logic circuit 150 as shown in FIG. 1) formed on the second substrate SUB2. The memory cell region MR may include a first substrate SUB1 and a memory cell array MCA (the memory cell array 110 illustrated in FIG. 1) formed on the first substrate SUB1.

The memory device 200 of the PoC structure illustrated in FIG. 2 and FIG. 3 and the memory device 300 of the CoP structure illustrated in FIG. 4 and FIG. 5 may have substantially similar wiring connection structures, except that the stacking order in the third direction D3 is reversed. For ease of description, below, memory devices below are described in the context of the PoC structure illustrated in FIG. 2 and FIG. 3. However, it will be understood that the disclosed devices and configurations are also applicable to CoP memory devices.

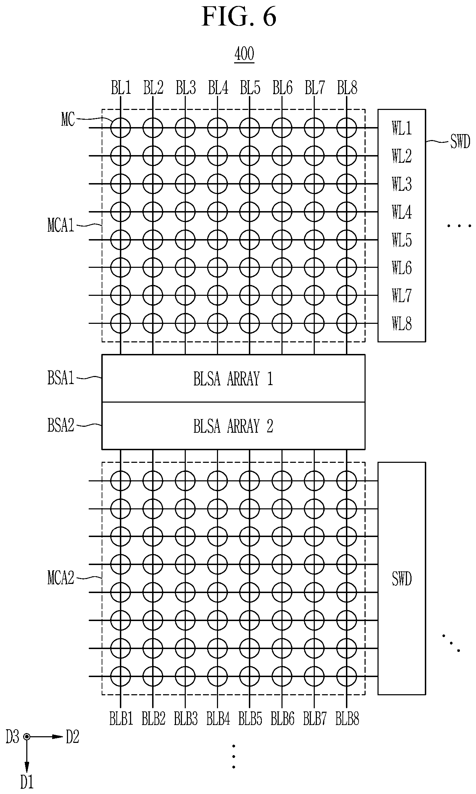

FIG. 6 is a diagram illustrating an example of a memory device. Referring to FIG. 6, the memory device 400 may include a plurality of memory cell arrays MCA1 and MCA2. The plurality of memory cell arrays MCA1 and MCA2 may include a first memory cell array MCA1 and a second memory cell array MCA2. The first memory cell array MCA1 and the second memory cell array MCA2 may be arranged spaced apart along the first direction D1. The first memory cell array MCA1 and the second memory cell array MCA2 may be positioned on the same first substrate SUB1 as shown in FIG. 2 and FIG. 3, for example.

The first memory cell array MCA1 may include a plurality of bit lines BL1 to BL8, a plurality of word lines WL1 to WL8, and a plurality of memory cells MC connected to the plurality of bit lines BL1 to BL8 and the plurality of word lines WL1 to WL8. The second memory cell array MCA2 may include a plurality of complementary bit lines BLB1 to BLB8.

In the sub-word line driver region SWD, sub-word line drivers may be disposed. The sub-word line driver may activate a specific word line among the plurality of word lines WL1 to WL8.

The memory device 400 may include a plurality of bit line sense amplifier arrays BSA1 and BSA2. The plurality of bit line sense amplifier arrays BSA1 and BSA2 may include a first bit line sense amplifier array BSA1 and a second bit line sense amplifier array BSA2.

The first bit line sense amplifier array BSA1 and the second bit line sense amplifier array BSA2 may each include a plurality of bit line sense amplifiers. The first bit line sense amplifier array BSA1 and the second bit line sense amplifier array BSA2 may be positioned on the same second substrate SUB2 as shown in FIG. 2 and FIG. 3, for example.

In FIG. 6, for better understanding and ease of description, the first bit line sense amplifier array BSA1 and the second bit line sense amplifier array BSA2 are depicted as being positioned between the separation spaces of the first memory cell array MCA1 and the second memory cell array MCA2 along the first direction D1, but the arrangements of the amplifier arrays and memory cell arrays is not limited thereto. For example, the first bit line sense amplifier array BSA1 may be placed on the first memory cell array MCA1 along the third direction D3 such that at least a portion of the first bit line sense amplifier array BSA1 overlaps the first memory cell array MCA1, and/or the second bit line sense amplifier array BSA2 may be placed on the second memory cell array MCA2 along the third direction D3 such that at least a portion of the second bit line sense amplifier array BSA2 overlaps the second memory cell array MCA2. Further discussion of arrangements of these elements will be provided below.

D1 and D2 may be lateral directions, e.g., parallel to a top and/or bottom surface of SUB1 and/or SUB2. D1 and D2 may be orthogonal or intersecting. D3 may be a vertical direction that is orthogonal to D1 and D2 and is orthogonal to top and/or bottom surfaces of SUB1 and/or SUB2.

Some of the bit lines among the plurality of bit lines BL1 to BL8 included in the first memory cell array MCA1 may be connected to the plurality of bit line sense amplifiers included in the first bit line sense amplifier array BSA1. Some of the remaining bit lines among the plurality of bit lines BL1 to BL8 included in the first memory cell array MCA1 may be connected to the plurality of bit line sense amplifiers included in the second bit line sense amplifier array BSA2.

Some of the complementary bit lines among the plurality of complementary bit lines BLB1 to BLB8 included in the second memory cell array MCA2 may be connected to the plurality of bit line sense amplifiers included in the first bit line sense amplifier array BSA1. Some of the remaining bit lines among the plurality of complementary bit lines BLB1 to BLB8 included in the second memory cell array MCA2 may be connected to the plurality of bit line sense amplifiers included in the second bit line sense amplifier array BSA2.

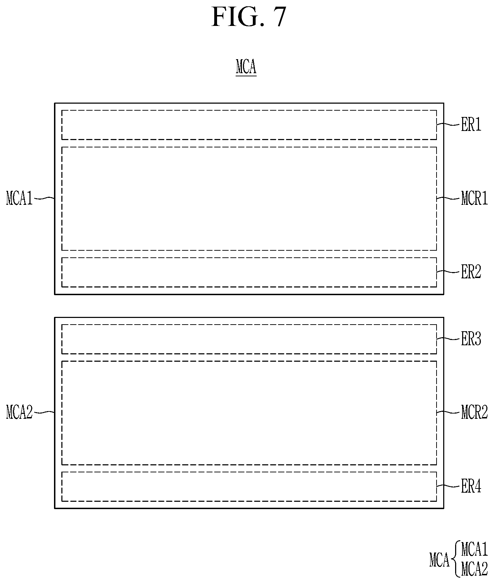

FIG. 7 is a diagram illustrating an example of a memory cell array included in a memory device.

Referring to FIG. 7, the memory cell array MCA may include a first memory cell array MCA1 and a second memory cell array MCA2. The first memory cell array MCA1 may include a first memory cell region MCR1 in which the plurality of memory cells are arranged, and a first edge region ER1 and a second edge region ER2 in which memory cells are not arranged. The first edge region ER1 may correspond to a region not adjacent to the second memory cell array MCA2 among the edge regions, and the second edge region ER2 may correspond to a region adjacent to the second memory cell array MCA2 among the edge regions. For example, ER1 may be an edge region opposite an edge region ER2 that is adjacent to the second memory cell array MCA2.

The second memory cell array MCA2 may include a second memory cell region MCR2 in which a plurality of memory cells are arranged, a third edge region ER3 and a fourth edge region ER4 in which memory cells are not arranged. The third edge region ER3 may correspond to a region adjacent to the first memory cell array MCA1 among the edge regions, and the fourth edge region ER4 may correspond to a region not adjacent to the first memory cell array MCA1 among the edge regions. For example, ER4 may be an edge region opposite an edge region ER3 that is adjacent to the first memory cell array MCA1.

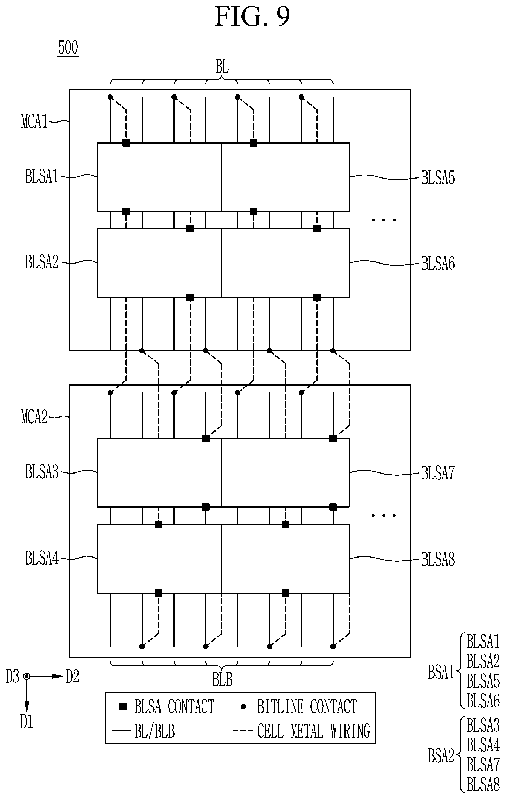

As described below in reference to FIG. 9, a plurality of bonding contacts may be arranged in the first edge region ER1 and the second edge region ER2, where the plurality of bit lines (BL1 to BL8 in FIG. 6) are connected to a cell metal wiring connecting the plurality of bit lines BL1 to BL8, and the first bit line sense amplifier array (BSA1 of FIG. 6) positioned on the first memory cell array MCA1 and the second bit line sense amplifier array (BSA2 of FIG. 6) positioned on the second memory cell array MCA2. Further, a plurality of bonding contacts may be arranged in the third edge region ER3 and the fourth edge region ER4, where the plurality of complementary bit lines (BLB1 to BLB8 of FIG. 6) are connected to a cell metal wiring connecting the plurality of complementary bit lines BLB1 to BLB8, and the first bit line sense amplifier array BSA1 positioned on the first memory cell array MCA1 and the second bit line sense amplifier array BSA2 positioned on the second memory cell array MCA2.

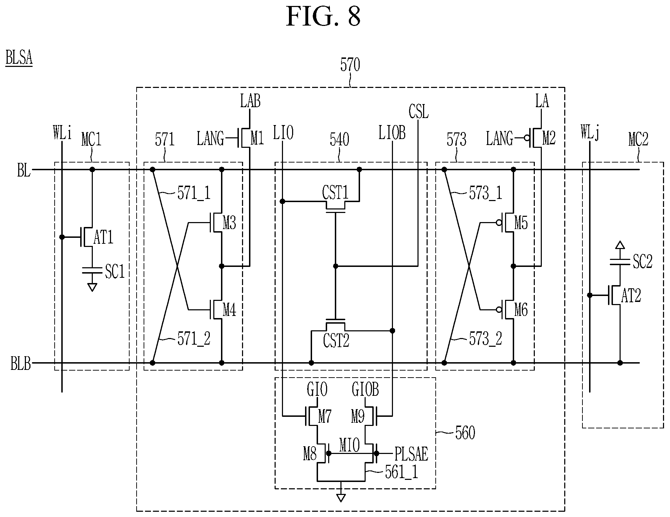

FIG. 8 is a diagram illustrating an example of a bit line sense amplifier included in a memory device, e.g., a BLSA included in BSA1 or BSA2.

Referring to FIG. 8, the bit line sense amplifier BLSA may be connected to the bit line BL and the complementary bit line BLB. The bit line BL may be one bit line among the plurality of bit lines BL1 to BL8 illustrated in FIG. 6, and the complementary bit line BLB may be one complementary bit line corresponding to the bit line BL among the plurality of complementary bit lines BLB1 to BLB8 illustrated in FIG. 6.

Bit line BL may be connected to the plurality of memory cells, and each of the plurality of memory cells may be connected to a memory cell of the plurality of word lines WL. Additionally, complementary bit line BLB may be connected to the plurality of memory cells, and each of the plurality of memory cells may be connected to a word line of the plurality of word lines WL.

In some implementations, the bit line sense amplifier BLSA may be connected to one bit line BL and a corresponding complementary bit line BLB. For ease of explanation, FIG. 8 illustrates one memory cell MC1 connected to the bit line BL, one word line WLi connected to the memory cell MC1, one memory cell MC2 connected to the complementary bit line BLB, and one word line WLj connected to the memory cell MC2.

Also, FIG. 8 shows that the memory cell MC1 includes a switching transistor AT1 and a capacitor SC1, and the memory cell MC2 includes a switching transistor AT2 and a capacitor SC2, but the structures of the memory cells MC1 and MC2 are not limited thereto.

The bit line sense amplifier BLSA 570 may include a N-type sense amplifier 571, a P-type sense amplifier 573, an input/output gate circuit 540, a local sense amplifier 560, and transistors M1 and M2. In some implementations, a plurality of transistors M1 to M10, CST1, and CST2 illustrated in FIG. 8 may be metal oxide semiconductor (MOS) transistors. In some implementations, the plurality of transistors M1, M3, M4, M7, M8, M9, M10, CST1, and CST2 may be n-channel transistors, for example, NMOS transistors. Additionally, the transistors M2, M5, and M6 may be p-channel transistors, for example, PMOS transistors. The transistors M1 to M10, CST1, and CST2 may have a source, a drain, and a gate thereof as a first input terminal, a second input terminal, and a control terminal, respectively. The transistor types are not limited to those described above.

The N-type sense amplifier 571 may include a third transistor M3 and a fourth transistor M4. The gate of the third transistor M3 may be electrically connected to the complementary bit line BLB through a conductive line 571_2. The gate of the fourth transistor M4 may be electrically connected to bit line BL through a conductive line 571_1. The source of the third transistor M3 and the source of the fourth transistor M4 may be electrically connected to the bit line BL and the complementary bit line BLB, respectively. The first voltage LAB may be input to the drain of the third transistor M3 and the drain of the fourth transistor M4 in response to the N-type sense amplifier driving signal LANG. The N-type sense amplifier driving signal LANG may have an active level (e.g., a high level) to turn on the first transistor M1 or an inactive level (e.g., a low level) to turn off the first transistor M1. The first voltage LAB may be a ground voltage.

The third transistor M3 and the fourth transistor M4 may be turned on or off depending on the voltage change of the bit line BL or the complementary bit line BLB. When the third transistor M3 is turned on, the first voltage LAB may be provided to the bit line BL. When the fourth transistor M4 is turned on, the first voltage LAB may be provided to the complementary bit line BLB.

The P-type sense amplifier 573 may include a fifth transistor M5 and a sixth transistor M6. The gate of the fifth transistor M5 may be electrically connected to the complementary bit line BLB through a conductive line 573_2. The gate of the sixth transistor M6 may be electrically connected to the bit line BL through a conductive line 573_1. The source of the fifth transistor M5 and the source of the sixth transistor M6 may be electrically connected to the bit line BL and the complementary bit line BLB, respectively. The second voltage LA may be input to the drain of the fifth transistor M5 and the drain of the sixth transistor M6 in response to the P-type sense amplifier driving signal LAPG. The P-type sense amplifier driving signal LAPG may have an active level (e.g., a low level) to turn on the second transistor M2 or an inactive level (e.g., a high level) to turn off the second transistor M2. The second voltage LA may be a power voltage.

The fifth transistor M5 and the sixth transistor M6 may be turned on or off depending on the voltage change of the bit line BL or the complementary bit line BLB. When the fifth transistor M5 is turned on, the second voltage LA may be provided to the bit line BL. When the sixth transistor M6 is turned on, the second voltage LA may be provided to the complementary bit line BLB.

The input/output gate circuit 540 may include a first column selection transistor CST1 and a second column selection transistor CST2. The drain of the first column selection transistor CST1 may be electrically connected to the bit line BL, and the drain of the second column selection transistor CST2 may be electrically connected to the complementary bit line BLB. The source of the first column selection transistor CST1 may be electrically connected to the local input/output line LIO, and the source of the second column selection transistor CST2 may be electrically connected to the complementary local input/output line LIOB. A column selection line CSL may be connected to the gate of the first column selection transistor CST1 and the gate of the first column selection transistor CST2. The bit line pair BL and BLB to which the sense amplifier 570 is connected may be connected to a local input/output line pair LIO and LIOB through the column selection transistors CST1 and CST2.

The column selection transistors CST1 and CST2 in the input/output gate circuit 540 may transmit potentials output from the N-type sense amplifier 571 and the P-type sense amplifier 573 to the local sense amplifier 560, respectively, in response to the column selection signal of the column selection line CSL.

The local sense amplifier 560 may include a seventh transistor M7, an eighth transistor M8, a ninth transistor M9, and a tenth transistor M10. The seventh transistor M7, the eighth transistor M8, the ninth transistor M9, and the tenth transistor M10 may be electrically connected within the local sense amplifier 560 via a conductive line 561_1.

A local enable signal PLSAE may be input to the gate of the eighth transistor M8 and the gate of the tenth transistor M10. The gate of the eighth transistor M8 and the tenth transistor M10 are turned on through the local enable signal PLSAE, so that the local sense amplifier 560 may be activated. When the local sense amplifier 560 is activated, the seventh transistor M7 and the ninth transistor M9 may invert the data of the local input/output line pair LIO and LIOB and output it to the global input/output line pair GIO and GIOB), respectively.

The bit line sense amplifier BLSA may operate as follows. First, when the word lines WLi and WLj are activated, the switching transistor AT1 of the memory cell MC1 is turned on, so that charges move between the bit line BL and the capacitor SC1 in the memory cell MC1, and the switching transistor AT2 of the memory cell MC2 is turned on, so that charges move between the complementary bit line BLB and the capacitor SC2 in the memory cell MC2. Afterwards, the N-type sense amplifier 571 or P-type sense amplifier 573 amplifies the potential difference between the bit line BL and the complementary bit line BLB. Then, when the column selection signal becomes an active level, the input/output gate circuit 540 may output the data of the bit line BL or the complementary bit line BLB through the local input/output line LIO or the complementary local input/output line LIOB, respectively. That is, in response to the column selection signal, the column selection transistors CST1 and CST2 in the input/output gate circuit 540 may transmit the potential output from the N-type sense amplifier 571 or the P-type sense amplifier 573 to the local sense amplifier 560. The local sense amplifier 560 is activated by the local enable signal PLSAE to invert the data of the received local input/output line pair LIO and LIOB and output it to the global input/output line pair GIO and GIOB.

The sense amplifier 570 may further include a precharge unit. The precharge unit may equalize the voltage of the bit line BL and the complementary bit line BLB to the precharge voltage before and after the operation of the N-type sense amplifier 571 or the P-type sense amplifier 573.

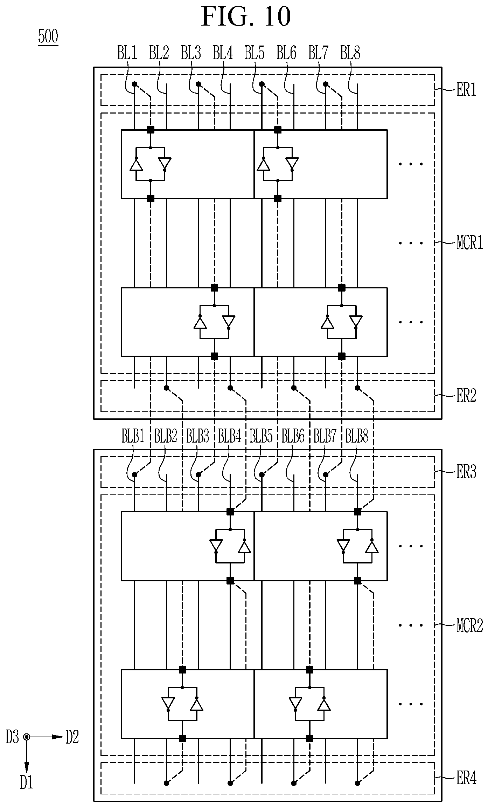

FIG. 9 and FIG. 10 are diagrams illustrating an example of a memory device. Referring to FIG. 9 and FIG. 10, a memory device 500 include a first memory cell array MCA1, and a second memory cell array MCA2 disposed adjacent to the first memory cell array MCA1 in the first direction D1. The first and second memory cell arrays MCA1, MCA2 may be adjacent and spaced apart from one another in the first direction D1. The first memory cell array MCA1 may include a plurality of bit lines BL1 to BL8 extending in the first direction D1. The second memory cell array MCA2 may include a plurality of complementary bit lines BLB1 to BLB8 corresponding to the plurality of bit lines BL1 to BL8 extending in the first direction D1.

The first bit line sense amplifier array BSA1 and the second bit line sense amplifier array BSA2 may each include a plurality of bit line sense amplifiers BLSA1 to BLSA8.

For example, the first bit line sense amplifier array BSA1 may include a first bit line sense amplifier BLSA1, a second bit line sense amplifier BLSA2, a fifth bit line sense amplifier BLSA5, and a sixth bit line sense amplifier BLSA6.

The second bit line sense amplifier array BSA2 may include a third bit line sense amplifier BLSA3, a fourth bit line sense amplifier BLSA4, a seventh bit line sense amplifier BLSA7, and an eighth bit line sense amplifier BLSA8.

The first bit line sense amplifier BLSA1 and the second bit line sense amplifier BLSA2 may be arranged spaced apart along the first direction D1. The fifth bit line sense amplifier BLSA5 and the sixth bit line sense amplifier BLSA6 may be arranged spaced apart along the first direction D1.

The first bit line sense amplifier BLSA1 and the fifth bit line sense amplifier BLSA5 may be arranged spaced apart along the second direction D2. The second bit line sense amplifier BLSA2 and the sixth bit line sense amplifier BLSA6 may be arranged spaced apart along the second direction D2.

The third bit line sense amplifier BLSA3 and the fourth bit line sense amplifier BLSA4 may be arranged spaced apart along the first direction D1. The seventh bit line sense amplifier BLSA7 and the eighth bit line sense amplifier BLSA8 may be arranged spaced apart along the first direction D1.

The third bit line sense amplifier BLSA3 and the seventh bit line sense amplifier BLSA7 may be arranged spaced apart along the second direction D2. The fourth bit line sense amplifier BLSA4 and the eighth bit line sense amplifier BLSA8 may be arranged spaced apart along the second direction D2.

The first bit line sense amplifier array BSA1 may be placed on the first memory cell array MCA1 such that at least a portion thereof overlaps the first memory cell array MCA1 along the third direction D3. The second bit line sense amplifier array BSA2 may be placed on the second memory cell array MCA2 such that at least a portion thereof overlaps the second memory cell array MCA2 along the third direction D3.

The memory device 500 may have a wiring connection structure such that, among data stored in a plurality of memory cells included in a first memory cell array MCA1, odd data is sensed by the first bit line sense amplifier array BSA1, and even data is sensed by the second bit line sense amplifier array BSA2.

For example, the first bit line BL1 and the first complementary bit line BLB1 corresponding thereto may be connected to the first bit line sense amplifier BLSA1, the third bit line BL3 and the third complementary bit line BLB3 corresponding thereto may be connected to the second bit line sense amplifier BLSA2, the fifth bit line BL5 and the fifth complementary bit line BLB5 corresponding thereto may be connected to the fifth bit line sense amplifier BLSA5, and the seventh bit line BL7 and the seventh complementary bit line BLB7 corresponding thereto may be connected to the sixth bit line sense amplifier BLSA6.

On the other hand, the second bit line BL2 and the second complementary bit line BLB2 corresponding thereto may be connected to the third bit line sense amplifier BLSA3, the fourth bit line BL4 and the fourth complementary bit line BLB4 corresponding thereto may be connected to the fourth bit line sense amplifier BLSA4, the sixth bit line BL6 and the sixth complementary bit line BLB6 corresponding thereto may be connected to the seventh bit line sense amplifier BLSA7, and the eighth bit line BL8 and the eighth complementary bit line BLB8 corresponding thereto may be connected to the eighth bit line sense amplifier BLSA8.

As described above, the cell metal wiring may connect the bit lines (and the complementary bit lines) and the bit line sense amplifier array positioned on different planes, and the cell metal wiring may be connected to the bit line (and the complementary bit line) through the bit line contact positioned in the edge region, and to bit line sense amplifier through the bit line sense amplifier contact.

For example, as shown in FIG. 10, the first bit line BL1, the third bit line BL3, the fifth bit line BL5, and the seventh bit line BL7 may each be connected to the cell metal wiring through a plurality of bit line contacts positioned at the first edge region ER1, and may be connected to the first bit line sense amplifier BLSA1, the second bit line sense amplifier BLSA2, the fifth bit line sense amplifier BLSA5, and the sixth bit line sense amplifier BLSA6 respectively through cell metal wiring.

The second bit line BL2, the fourth bit line BL4, the sixth bit line BL6, and the eighth bit line BL8 may each be connected to the cell metal wiring through the plurality of bit line contacts positioned at the second edge region ER2, and may be connected to the third bit line sense amplifier BLSA3, the fourth bit line sense amplifier BLSA4, the seventh bit line sense amplifier BLSA7, and the eighth bit line sense amplifier BLSA8 respectively through the cell metal wiring.

The first complementary bit line BLB1, the third complementary bit line BLB3, the fifth complementary bit line BLB5, and the seventh complementary bit line BLB7 may each be connected to the cell metal wiring through the plurality of bit line contacts positioned at the third edge region ER3, and may be connected to the first bit line sense amplifier BLSA1, the second bit line sense amplifier BLSA2, the fifth bit line sense amplifier BLSA5, and the sixth bit line sense amplifier BLSA6 respectively through the cell metal wiring.

The second complementary bit line BLB2, the fourth complementary bit line BLB4, the sixth complementary bit line BLB6, and the eighth complementary bit line BLB8 may each be connected to the cell metal wiring through the plurality of bit line contacts positioned at the fourth edge region ER4, and may be connected to the third bit line sense amplifier BLSA3, the fourth bit line sense amplifier BLSA4, the seventh bit line sense amplifier BLSA7, and the eighth bit line sense amplifier BLSA8 respectively through a cell metal wiring.

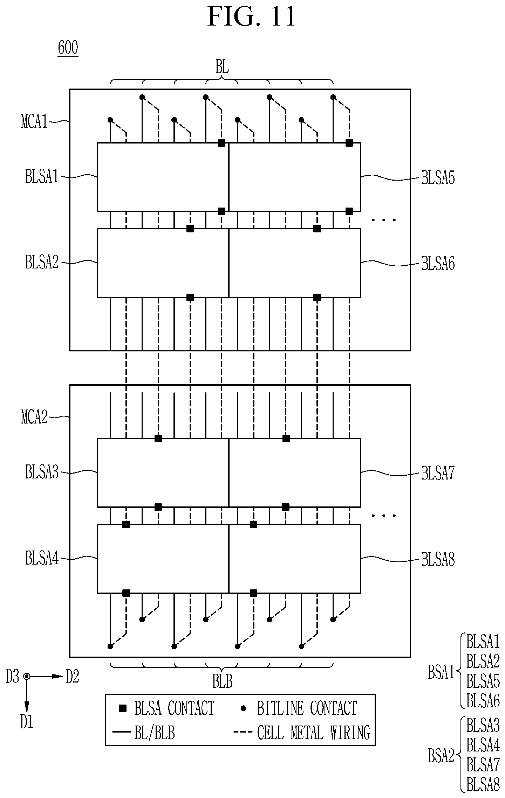

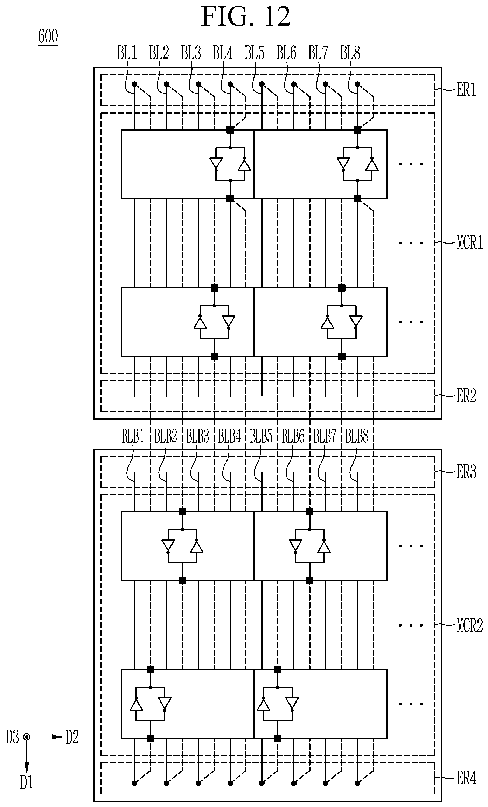

FIG. 11 and FIG. 12 are diagrams illustrating an example of a memory device. Below, differences from the memory device 500 described with respect to FIG. 9 and FIG. 10 are mainly described. The description provided for elements of the memory device 500 applies equally to corresponding elements of the memory device 600 of FIGS. 11 and 12, except where noted otherwise or suggested otherwise by context.

Referring to FIG. 11 and FIG. 12, a memory device 600 may have a structure in which two bit lines (and two complementary bit lines corresponding thereto) adjacent to each other are connected to the first bit line sense amplifier array BSA1, and two adjacent bit lines (and two complementary bit lines corresponding thereto) sequentially arranged in the second direction D2 for two bit lines are connected to the second bit line sense amplifier array BSA2.

For example, the first bit line BL1 and the first complementary bit line BLB1 corresponding thereto may be connected to the fourth bit line sense amplifier BLSA4, the second bit line BL2 and the second complementary bit line BLB2 corresponding thereto may be connected to the third bit line sense amplifier BLSA3, the third bit line BL3 and the third complementary bit line BLB3 corresponding thereto may be connected to the second bit line sense amplifier BLSA2, and the fourth bit line BL4 and the fourth complementary bit line BLB4 corresponding thereto may be connected to the first bit line sense amplifier BLSA1.

The fifth bit line BL5 and the fifth complementary bit line BLB5 corresponding thereto may be connected to the eighth bit line sense amplifier BLSA8, the sixth bit line BL6 and the sixth complementary bit line BLB6 corresponding thereto may be connected to the seventh bit line sense amplifier BLSA7, the seventh bit line BL7 and the seventh complementary bit line BLB7 corresponding thereto may be connected to the sixth bit line sense amplifier BLSA6, and the eighth bit line BL8 and the eighth complementary bit line BLB8 corresponding thereto may be connected to the fifth bit line sense amplifier BLSA5.

In some implementations, unlike some implementations of the cell metal wiring of the memory device 500 shown in FIG. 9 and FIG. 10, the cell metal wiring of the memory device 600 illustrated in FIG. 11 and FIG. 12 may be connected to the plurality of bit lines through bit line contacts positioned at the outer edge regions, rather than the edge region where the first memory cell array MCA1 and the second memory cell array MCA2 are adjacent to each other.

For example, the first to eighth bit lines BL1 to BL8 may each be connected to the cell metal wiring through the plurality of bit line contacts positioned in the first edge region ER1 that is not adjacent to the second memory cell array MCA2, and may be connected to the fourth bit line sense amplifier BLSA4, the third bit line sense amplifier BLSA3, the second bit line sense amplifier BLSA2, the first bit line sense amplifier BLSA1, the eighth bit line sense amplifier BLSA8, the seventh bit line sense amplifier BLSA7, the sixth bit line sense amplifier BLSA6, and the fifth bit line sense amplifier BLSA5 through the cell metal wiring, respectively.

The first to eighth complementary bit lines BLB1 to BLB8 may each be connected to the cell metal wiring through the plurality of bit line contacts positioned at the fourth edge region ER4 that is not adjacent to the first memory cell array MCA1, and may be connected to the fourth bit line sense amplifier BLSA4, the third bit line sense amplifier BLSA3, the second bit line sense amplifier BLSA2, the first bit line sense amplifier BLSA1, the eighth bit line sense amplifier BLSA8, the seventh bit line sense amplifier BLSA7, the sixth bit line sense amplifier BLSA6, and the fifth bit line sense amplifier BLSA5 through the cell metal wiring, respectively.

FIG. 9 to FIG. 12 illustrate examples of relationships of cell metal wiring and bit line contact connections for the purposes of understanding, but an wiring and contact connections are not limited thereto, and the connection relationship of the cell metal wiring and the bit line contact may be implemented in various ways considering the integration and process methods of memory devices, without departing from the scope of this disclosure.

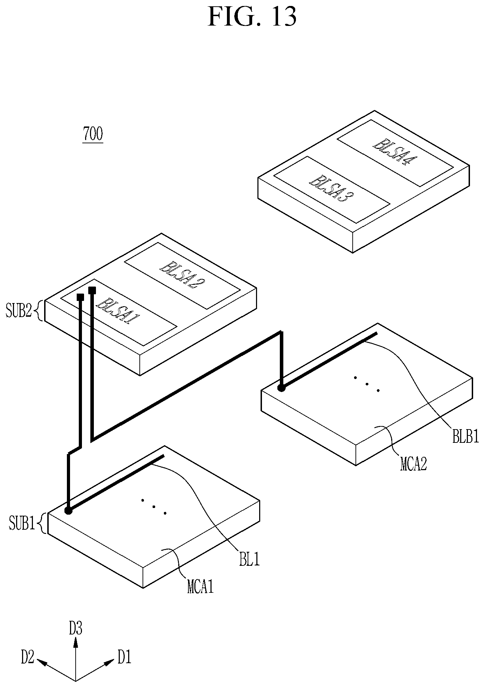

FIG. 13 is a perspective diagrammatic view illustrating an example of a memory device. Referring to FIG. 13, a memory device 700 may include a first memory cell array MCA1, a second memory cell array MCA2 disposed adjacent to the first memory cell array MCA1 in the first direction D1, a first bit line sense amplifier BLSA1 and a second bit line sense amplifier BLSA2 having at least a portion overlapping the first memory cell array MCA1 in the third direction D3, and a third bit line sense amplifier BLSA3 and a fourth bit line sense amplifier BLSA4 having at least a portion overlapping the second memory cell array MCA2 in the third direction D3.

The first memory cell array MCA1 and the second memory cell array MCA2 may be positioned on the same first substrate SUB1 as described above, and the first to fourth bit line sense amplifiers BLSA1 to BLSA4 may be positioned on the same second substrate SUB2 as described above.

The first bit line BL1 included in the first memory cell array MCA1 may be connected to the first bit line sense amplifier BLSA1 through the cell metal wiring extending in the first direction D1, and the first complementary bit line BLB1 included in the second memory cell array MCA2 may be connected to the first bit line sense amplifier BLSA1 through cell metal wiring extending in the first direction D1.

In FIG. 13, for ease of description and illustration, the pair of a bit line and the complementary bit line corresponding thereto, and the cell metal wiring connecting them, are illustrated, but further bit lines, complementary bit lines, and cell metal wiring may be included to connect to the bit line sense amplifiers as described herein.

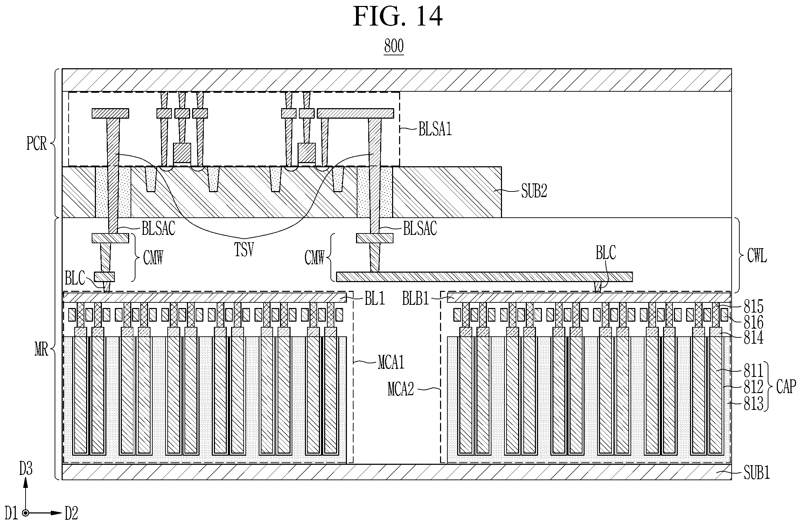

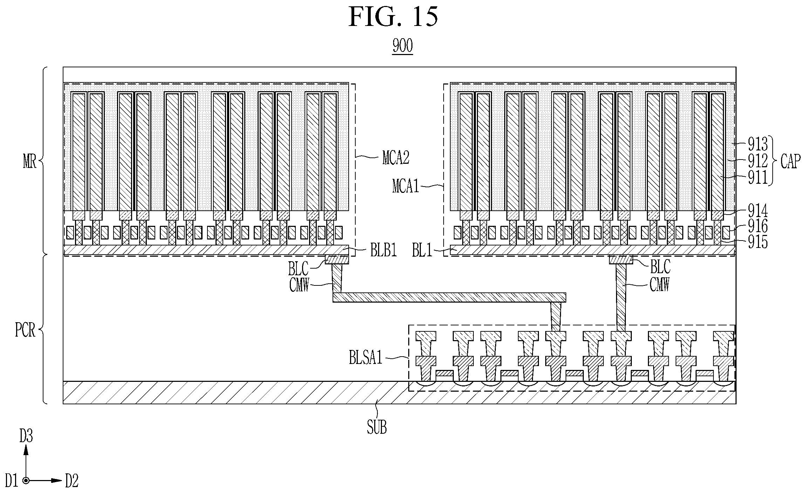

FIG. 14 and FIG. 15 are cross-sectional views of examples of memory devices. Specifically, FIG. 14 is the cross-sectional view along the line C-C' of FIG. 2, and FIG. 15 is the cross-sectional view along the line C-C' of FIG. 4. The memory devices illustrated in FIG. 14 and FIG. 15 have substantially the similar wiring connection relationships, with only a difference in the stacking order; therefore, the detailed wiring connection relationships are described below with reference to FIG. 14, and will be understood as applying equally to FIG. 15.

Referring to FIG. 14, the memory device 800 may include a memory region MR and a peripheral circuit region PCR. The memory region MR may include a first substrate SUB1, a plurality of memory cell array MCA1 and MCA2 formed on the first substrate SUB1, and a cell wiring layer CWL for connecting the plurality of memory cell array MCA1 and MCA2 and a peripheral circuit region PCR. The peripheral circuit region PCR may include a second substrate SUB2 and a first bit line sense amplifier BLSA1 formed on the second substrate SUB2.

The first memory cell array MCA1 and the second memory cell array MCA2 may each include substantially the same plurality of cell structures. For example, each memory cell array MCA1 and MCA2 may include a capacitor structure CAP, a capacitor contact 814, a memory channel layer 815, and a gate electrode 816.

The capacitor structure CAP may include a lower electrode 811, a capacitor dielectric layer 812, and an upper electrode 813. The lower electrode 811 may be electrically connected to the capacitor contact 814. The lower electrode 811 may be formed as a pillar type extending in the third direction D3. However, the scope of the present disclosure is not limited to cell configuration.

The memory channel layer 815 may be placed on the capacitor contact 814. That is, the memory channel layer 815 may be stacked in the third direction D3 on the capacitor contact 814.

The gate electrode 816 may extend from both sides of the memory channel layer 815 to the first direction D1. An interlayer insulating layer may be placed between the gate electrode 816 and the memory channel layer 815. The interlayer insulating layer may be formed of a single continuous layer of a material or a plurality of insulating patterns.

The first memory cell array MCA1 may include the first bit line BL1. The second memory cell array MCA2 may include a first complementary bit line BLB1. The first bit line BL1 and the first complementary bit line BLB1 may be extended along the second direction D2.

The cell wiring layer CWL may be disposed on the first memory cell array MCA1 and the second memory cell array MCA2. The cell wiring layer CWL may include a bit line contact BLC in which a bit line (and a complementary bit line) and the cell metal wiring are connected, a cell metal wiring CMW for connecting the bit line (and the complementary bit line) and the peripheral circuit region PCR, and a bit line sense amplifier contact BLSAC in which the cell metal wiring CMW and a through-silicon via TSV are connected.

For example, the first bit line BL1 may be connected to the cell metal wiring CMW through the bit line contact BLC. The first complementary bit line BLB1 may be connected to the cell metal wiring CMW via the bit line contact BLC. The cell metal wiring CMW connected to the first bit line BL1 may be positioned on the first memory cell array MCA1, and the cell metal wiring CMW connected to the first complementary bit line BLB1 may be positioned on the first memory cell array MCA1 and the second memory cell array MCA2.

The cell metal wiring CMW may extend along the second direction D2 and be connected to the plurality of through-silicon via TSVs in the peripheral circuit region PCR through bit line sense amplifier contact BLSAC.

The peripheral circuit region PCR may include a second substrate SUB2 and a first bit line sense amplifier BLSA1 formed thereon. The peripheral circuit region PCR may include an interlayer insulating layer, a plurality of circuit elements formed on the second substrate SUB2, and a plurality of metal layers connected to the plurality of circuit elements. Each of the plurality of metal layers may be implemented with materials having different resistances.

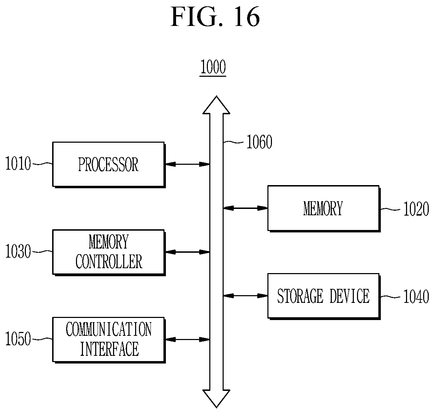

FIG. 16 is a block diagram illustrating an example of a computer device. Referring to FIG. 16, a computing device 1000 includes a processor 1010, a memory 1020, a memory controller 1030, a storage device 1040, a communication interface 1050, and a bus 1060. The computing device 1000 may further include other general-purpose components.

The processor 1010 may control the overall operation of each component of the computing device 1000. The processor 1010 may be implemented with at least one of various processing units, such as a central processing unit (CPU), an AP (application processor), or a graphics processing unit (GPU).

The memory 1020 may store various data and instructions. The memory 1020 may be implemented as a memory device as described with reference to FIG. 1 to FIG. 15.

The memory controller 1030 may control the transferring of the data or instructions to and from the memory 1020. In some implementations, the memory controller 1030 may be provided as a separate chip from the processor 1010. In some implementations, the memory controller 1030 may be provided as an internal component of the processor 1010.

The storage device 1040 may non-temporarily store programs and data. In some implementations, the storage device 1040 may be implemented as a non-volatile memory.

The communication interface 1050 may support wired and wireless Internet communication of the computing device 1000. Additionally, the communication interface 1050 may support various communication methods other than Internet communication.

The bus 1060 may provide communication functions between components of the computing device 1000. Bus 1060 may include at least one type of bus depending on the communication protocol between components.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A memory device (100-800) comprising:
a first memory cell array (MCA1) including a plurality of bit lines (BL1-BL8);
a second memory cell array (MCA2) including a plurality of complementary bit lines (BLB1-BLB8) corresponding to the plurality of bit lines (BL1-BL8), respectively, wherein the second memory cell array (MCA2) is arranged adjacent to the first memory cell array (MCA1) in a first lateral direction (D1); and
a first bit line sense amplifier array (BSA1) that at least partially overlaps the first memory cell array (MCA1) along a vertical direction (D3), wherein the first bit line sense amplifier array (BSA1) comprises:
a plurality of first bit line sense amplifiers (BLSA1, BLSA2, BLSA5, BLSA6) connected to (i) a plurality of first bit lines (BL1, BL3, BL5, BL7) of the plurality of bit lines (BL1-BL8) and (ii) a plurality of first complementary bit lines (BLB1, BLB3, BLB5, BLB7) of the plurality of complementary bit lines (BLB1-BLB8).

2. The memory device (100-800) of claim 1, wherein:
the first memory cell array (MCA1) is on a first substrate (SUB1), and
the first bit line sense amplifier array (BSA1) is on a second substrate (SUB2) that is above the first substrate (SUB1).

3. The memory device (100-800) of claim 2, wherein the second memory cell array (MCA2) is on the first substrate (SUB1).

4. The memory device (100-800) of any one of claims 1 to 3, further comprising:
a second bit line sense amplifier array (BSA2) that at least partially overlaps the second memory cell array (MCA2) along the vertical direction (D3), wherein the second bit line sense amplifier array (BSA2) comprises:
a plurality of second bit line sense amplifiers (BLSA3, BLSA4, BLSA7, BLSA8) connected to (i) a plurality of second bit lines (BL2, BL4, BL6, BL8), different from the plurality of first bit lines (BL1, BL3, BL5, BL7), of the plurality of bit lines (BL1-BL8), and (ii) a plurality of second complementary bit lines (BLB2, BLB4, BLB6, BLB8), different from the plurality of first complementary bit lines (BLB1, BLB3, BLB5, BLB7), of the plurality of complementary bit lines (BLB1-BLB8).

5. The memory device (100-800) of claim 4, wherein the second bit line sense amplifier array (BSA2) is on a same substrate as the first bit line sense amplifier array (BSA1).

6. The memory device (100-800) of claim 4 or 5,
wherein the plurality of first bit lines (BL1, BL3, BL5, BL7) are connected to a plurality of first cell wirings, wherein the plurality of first cell wirings are connected to the plurality of first bit line sense amplifiers (BLSA1, BLSA2, BLSA5, BLSA6) through a plurality of first bonding contacts that are in a first edge region (ER1) of the first memory cell array (MCA1), wherein the first edge region (ER1) is non-adjacent to the second memory cell array (MCA2), and
wherein the plurality of second bit lines (BL2, BL4, BL6, BL8) are connected to a plurality of second cell wirings, wherein the plurality of second cell wirings are connected to the plurality of second bit line sense amplifiers (BLSA3, BLSA4, BLSA7, BLSA8) through a plurality of second bonding contacts that are in a second edge region (ER2) of the first memory cell array (MCA1), wherein the second edge region (ER2) is adjacent to the second memory cell array (MCA2).

7. The memory device (100-800) of any one of claims 4 to 6,
wherein the plurality of first complementary bit lines (BLB1, BLB3, BLB5, BLB7) are connected to a plurality of third cell wirings, wherein the plurality of third cell wirings are connected to the plurality of first bit line sense amplifiers (BLSA1, BLSA2, BLSA5, BLSA6) through a plurality of third bonding contacts that are in a third edge region (ER3) of the second memory cell array (MCA2), wherein the third edge region (ER3) is adjacent to the first memory cell array (MCA1), and
wherein the plurality of second complementary bit lines (BLB2, BLB4, BLB6, BLB8) are connected to a plurality of fourth cell wirings, wherein the plurality of fourth cell wirings are connected to the plurality of second bit line sense amplifiers (BLSA3, BLSA4, BLSA7, BLSA8) through a plurality of fourth bonding contacts that are in a fourth edge region (ER4) of the second memory cell array (MCA2), wherein the second edge region (ER2) is non-adjacent to the first memory cell array (MCA1).

8. The memory device (100-800) of claim 7, wherein:
the plurality of bit lines (BL1-BL8) and the plurality of complementary bit lines (BLB1-BLB8) extend in the first lateral direction (D1), and
the plurality of first cell wirings, the plurality of second cell wirings, the plurality of third cell wirings, and the plurality of fourth cell wirings extend in the first lateral direction (D1).

9. The memory device (100-800) of claim 7 or 8, comprising a cell wiring layer on the first memory cell array (MCA1) and the second memory cell array (MCA2),
wherein the plurality of first cell wirings, the plurality of second cell wirings, the plurality of third cell wirings, and the plurality of fourth cell wirings are on the cell wiring layer.

10. The memory device (100-800) of any one of claims 4 to 9, wherein:
the plurality of first bit lines (BL1, BL3, BL5, BL7) and the plurality of second bit lines (BL2, BL4, BL6, BL8) are arranged alternately along a second lateral direction (D2) intersecting the first lateral direction (D1), and
the plurality of first complementary bit lines (BLB1, BLB3, BLB5, BLB7) and the plurality of second complementary bit lines (BLB2, BLB4, BLB6, BLB8) are arranged alternately along the second lateral direction (D2).

11. The memory device (100-800) of any one of claims 4 to 10, wherein:
two first bit line sense amplifiers (BLSA1, BLSA2), of the plurality of first bit line sense amplifiers (BLSA1, BLSA2, BLSA5, BLSA6), are connected to two adjacent first bit lines of the plurality of first bit lines (BL1, BL3, BL5, BL7),
wherein one second bit line of the plurality of second bit lines (BL2, BL4, BL6, BL8) is disposed between the two adjacent first bit lines, and
wherein the two first bit line sense amplifiers (BLSA1, BLSA2) are spaced apart in the first lateral direction (D1).

12. The memory device (100-800) of any one of claims 4 to 11,
wherein the plurality of first bit lines (BL1, BL3, BL5, BL7) are connected to a plurality of first cell wirings, wherein the plurality of first cell wirings are connected to the plurality of first bit line sense amplifiers (BLSA1, BLSA2, BLSA5, BLSA6) through a plurality of first bonding contacts that are in a first edge region (ER1) of the first memory cell array (MCA1), wherein the first edge region (ER1) is non-adjacent to the second memory cell array (MCA2), and
wherein the plurality of second bit lines (BL2, BL4, BL6, BL8) are connected to a plurality of second cell wirings, wherein the plurality of second cell wirings are connected to the plurality of second bit line sense amplifiers (BLSA3, BLSA4, BLSA7, BLSA8) through a plurality of second bonding contacts that are in the first edge region (ER1).

13. The memory device (100-800) of claim 12,
wherein the plurality of first complementary bit lines (BLB1, BLB3, BLB5, BLB7) are connected to a plurality of third cell wirings, wherein the plurality of third cell wirings are connected to the plurality of first bit line sense amplifiers (BLSA1, BLSA2, BLSA5, BLSA6) through a plurality of third bonding contacts that are in a second edge region (ER2) of the second memory cell array (MCA2), wherein the second edge region (ER2) is non-adjacent to the first memory cell array (MCA1), and
wherein the plurality of second complementary bit lines (BLB2, BLB4, BLB6, BLB8) are connected to a plurality of fourth cell wirings, wherein the plurality of fourth cell wirings are connected to the plurality of second bit line sense amplifiers (BLSA3, BLSA4, BLSA7, BLSA8) through a plurality of fourth bonding contacts that are in the second edge region (ER2).

14. The memory device (100-800) of any one of claims 4 to 13, wherein:
two adjacent first bit lines, of the plurality of first bit lines (BL1, BL3, BL5, BL7), and two adjacent second bit lines, of the plurality of second bit lines, are arranged alternately along a second lateral direction (D2) intersecting the first lateral direction (D1), and
two adjacent first complementary bit lines, of the plurality of first complementary bit lines (BLB1, BLB3, BLB5, BLB7), and two adjacent second complementary bit lines, of the plurality of second complementary bit lines (BLB2, BLB4, BLB6, BLB8), are arranged alternately along the second lateral direction (D2).

15. The memory device (100-800) of any one of claims 1 to 14, wherein:
two first bit line sense amplifiers (BLSA1, BLSA2), of the plurality of first bit line sense amplifiers (BLSA1, BLSA2, BLSA5, BLSA6), are connected to the two adjacent first bit lines, and
wherein the two first bit line sense amplifiers (BLSA1, BLSA2) are spaced apart in the first lateral direction (D1).
